(19) Europäisches Patentamt

European Patent Office

Office européen des brevets

(11) **EP 1 463 382 A1**

(12) **EUROPEAN PATENT APPLICATION**

(43) Date of publication:
**29.09.2004 Bulletin 2004/40**

(51) Int Cl.$^7$: **H05B 3/68**, H05B 3/20, H01L 21/027, H05B 3/14

(21) Application number: **04013360.5**

(22) Date of filing: **01.05.2001**

(84) Designated Contracting States:
**AT BE CH CY DE DK ES FI FR GB GR IE IT LI LU MC NL PT SE TR**

(30) Priority: **02.05.2000 JP 2000133534**
**04.10.2000 JP 2000305175**

(62) Document number(s) of the earlier application(s) in accordance with Art. 76 EPC:
**01926082.7 / 1 211 912**

(71) Applicant: **IBIDEN CO., LTD.**
**Ogaki-shi Gifu-ken 503-8604 (JP)**

(72) Inventor: **Hiramatsu, Yasuji**
**Ibi-gun Gifu 501-0695 (JP)**

(74) Representative: **Gillard, Marie-Louise et al**
**Cabinet Beau de Loménie,**
**158, rue de l'Université**
**75007 Paris (FR)**

Remarks:
This application was filed on 07 - 06 - 2004 as a divisional application to the application mentioned under INID code 62.

(54) **Hot plate unit**

(57)     The purpose of the present invention is to provide a hot plate unit (10) capable of carrying out temperature-rising and temperature-falling sufficiently quickly even if the diameter of a substrate (11) becomes wide and with which apparatus can be downsized. The present invention provides a hot plate unit (10) comprising a supporting case (22) and a substrate (11) equipped with a temperature adjustment means; said substrate (11) being fitted to the supporting case (22), wherein the thickness of the supporting case (22) is 50 mm or less.

Fig. 2

EP 1 463 382 A1

**Description**

Technical Field

The present invention relates to a hot plate unit to be used mainly in semiconductor industries and more particularly a hot plate unit excellent in the temperature-dropping property since it is a thin type.

Background Art

Asemiconductorproduct ismanufacturedby steps of forming a photosensitive resin as an etching resist on a semiconductor wafer, etching the semiconductor wafer and the like.
The photosensitive resin is a liquid and to be applied to the surface of the semiconductor wafer by a spin coater and the like and requires to be dried in order to evaporate a solvent and the like after the coating, and therefore the coated semiconductor wafer has to be heated while being put on a heater.
Conventionally, as a heater made of a metal to be used for such a purpose, aluminum plate having a heating element disposed on the back face have been employed.
However, such a heater made of a metal has the following problems.
At first, since it is made of a metal, the thickness of the metal plate is required to be at least about 15 mm. It is because in the case of a thin metal plate, warping, straining and the like take place owing to the thermal expansion attributed to the heating to result in a damage or inclination of a semiconductor wafer put on the metal plate. However, if the thickness of the metal plate is made thick, the weight of the heater itself increases to cause another problem, that the heater becomes bulky.
Further, the heating temperature is controlledby changing the voltage and the electric current amount to be applied to the heating element and hence, there is another problem that since the metal plate is thick and the heat capacity is large, the temperature of the heater plate cannot quickly follow the change of the voltage and the electric current amount and the temperature control becomes difficult.
Therefore, as described in JP Kokai Hei 9 - 306642 and JP Kokai Hei 4 - 324276 and the like, a ceramic heater is proposed, in which AlN, a non-oxide ceramic with a high thermal conductivity and strength, is used as a substrate and a heating element is formed on the surface of the AlN substrate or inside thereof.

Summary of the Invention

Such a ceramic heater (a hot plate unit) is generally a heater comprising such a ceramic substrate fitted to a supporting case and since a wiring is housed in the supporting case, the thickness of the supporting case is dominantly made thicker than 50 mm.
On the other hand, the ceramic heater (the hot plate unit) is required to be cooled in order to control the temperature thereof and especially required is a supporting case capable of dealing with the quick and forcible cooling.
However, a conventional hot plate unit has a problem that it is difficult to respond to the quick and forcible cooling.
Inventors of the present invention have enthusiastically made investigations to solve the above-mentioned problems and consequently found that, for the adjustment of the temperature of the heating substrate equipped with a temperature adjustment means such as a ceramic heater (a hot plate unit) and the like, quick temperature drop can be achieved by: decreasing the volume of a supporting case by thinning the thickness of the supporting case to be 50 mm or less; and quickening the air ventilation and circulation in the supporting case, in the case of carrying out cooling using a cooling gas or a cooling liquid (a coolant) , and thus the present invention has been completed.
That is, a first aspect of the present invention is a hot plate unit comprising a supporting case and a substrate (a heating substrate) equipped with a temperature adjustment means, the substrate being fitted to the supporting case, wherein the thickness of the supporting case is 50 mm or less.
It should be noted that, in this specification, the term, thickness of the supporting case, is practically the thickness of a space where a cooling medium (a coolant) is circulated and represents a distance from the bottom of the heating substrate to the bottom part of the supporting case, and in the case of no bottom plate, it represents: the thickness from the bottom of the heating substrate to the lowest part of the outer frame of the supporting case; or the thickness of the outer frame of the supporting case. Further, if an intermediate bottom plate is formed, the thickness is defined as the thickness of the range where a coolant for cooling is circulated, and if the coolant for cooling is circulated only as far as the intermediate bottom plate, the thickness represents the distance from the bottom of the heating substrate to the intermediate bottom plate of the supporting case, and if the coolant for cooling is circulated to the bottom plate, the thickness is the distance from the bottom of the heating substrate to the bottom plate, or the thickness of the outer frame.

In the above-mentioned hot plate unit, since the thickness of the above-mentioned supporting case is 50 mm or less, the volume of the supporting case is small and a supplied coolant is brought into contact with a heating substrate made of a ceramic substrate or a metal substrate to exchange heat and the coolant which receives heat is quickly discharged out of the case and at the same time a new low temperature coolant is quickly supplied, so that quick temperature drop can be achieved.

Especially, in the case of a large size hot plate unit with the diameter exceeding 150 mm, the thickness is preferable to be 30 mm or less. Because rapid temperature drop can be performed even if the diameter is large.

Further, the ratio of the thickness 1 of the above-mentioned substrate to the thickness L of the supporting case is preferably $0.02 \leqq 1/L$. That is because if $1/L$ is below 0.02, that is, the thickness L of the supporting case is too thick relatively to the thickness 1 of the heating substrate (a ceramic substrate, a metal substrate, and the like), the discharge of the heat exchanged coolant is retarded and the cooling speed is slowed down.

It is preferable for $1/L$ to be 10 or less ($10 \geqq 1/L$). That is because if $1/L$ exceeds 10, the thickness 1 of the heating substrate is too thick relatively to the thickness L of the supporting case and the heat capacity becomes too high, resulting in slow down of the cooling speed.

It should be noted that the temperature adjustment means mentioned above is desirably a resistance heating element. That is because a resistance heating element is easily provided on the heating substrate and thereby adjusting the temperature of the hot plate unit is conducted relatively easier.

Further, the temperature adj ustment means mentioned above is desirably a cooling means. When cooling down the heated hot plate unit, this enables to cool it down promptly.

Further, a second aspect of the present invention is a hot plate unit comprising a supporting case and a substrate equippedwith a temperature adj ustmentmeans ; the substrate being fitted to the supporting case,

wherein the ratio of the thickness 1 of the substrate to the thickness L of the supporting case satisfies $0.02 \leqq 1/L$.

In the second aspect of the present invention, since the ratio of the thickness 1 of the substrate to the thickness L of the supporting case satisfies $0.02 \leqq 1/L$, the thickness L of the supporting case is thin when compared with the thickness 1 of the substrate and the discharge of the heat exchanged coolant is accelerated, thereby this enables to cool down the substrate promptly.

It should be noted that it is desirable for $1/L$ to be 10 or less. As described above, in case that $1/L$ exceeds 10, the thickness of the heating substrate is thick when compared with the supporting case, and the heat capacity becomes too large, thus resulting in slow down of the cooling speed.

In the second aspect of the present invention, the thickness of the above-mentioned supporting case is preferably 50 mm or less. Since the volume of a part where a coolant ventilates is small, quick temperature drop can be performed because of the above-mentioned reason.

Further, also in the second aspect of the present invention, the above-mentioned temperature adjustment means is preferably a resistance heating element and the above-mentioned temperature adjustment means is preferably a cooling means.

Further, a third aspect of the present invention is a hot plate unit comprising a supporting case and a ceramic substrate equipped with a resistance heating element composed of one or more circuit (s) ; the substrate being fitted to the supporting case,

wherein the thickness of the supporting case is 50 mm or less.

In a hot plate with such a structure, as described above, since the volume of a part where a coolant is ventilated is small, quick temperature drop can be achieved.

Further, because of the reason described above, the ratio of the thickness 1 of the above-mentioned substrate to the thickness L of the supporting case is preferably $0.02 \leqq 1/L$. Further, $1/L$ is preferably 10 or less.

In the third aspect of the present invention, a conductive wire connected to an end portion of the above-mentioned resistance heating element and/or a wiring led out of a heat-measuring element installed in the above-mentioned ceramic substrate are/is withdrawn from a through hole formed in the above-mentioned bottom plate, so that the coolant is made easy to be circulated.

Further, since a coolant can be blown directly to the ceramic substrate by disposing the coolant introducing pipe in the above-mentioned bottom plate, rapid temperature drop can be carried out.

Further, in the first through the third aspects of the present invention, cooling may be carried out by disposing pipes and rings in the outside of the supporting case and passing a coolant through the pipes and the rings.

Further, as a temperature adjustment means, the resistance heating elements may be disposed on the surface or inside of the heating substrate or, a space to let a heated oil pass into may be formed inside the heating substrate.

As the coolant, a gas or a liquid may be used. As a gas, usable are, for example, an inert gas such as argon, helium and the like other than air, nitrogen, and carbon dioxide. As a liquid, usable are, for example, water, ammonia, ethylene glycol and the like. As the heating substrate, usable are a ceramic substrate and a metal substrate.

As described above, in the first aspect of the present invention, the type of the substrates is not restricted but the thickness of the supporting case is restricted; in the second aspect of the present invention, the type of the substrate is not restricted but the ratio of the thickness 1 of the substrate to the thickness L of the supporting case is restricted; and in the third aspect of the present invention, the substrate is a ceramic substrate equipped with resistance heating element and the thickness of the supporting case is restricted. Thus, the construction of each aspect of the present invention differs from one another, but the hot plate units are in common at a point that they are all equipped with a substrate and a supporting case, respectively.

Hence, hereinafter, description will be given of a hot plate unit equipped with: a substrate comprising a ceramic substrate or a metal substrate; wherein a supporting case preferably has the thickness of 50 mm or less and the ratio of the thickness 1 of the substrate to the thickness L of the supporting case is preferably $0.02 \leqq 1 /L$, as a hot plate unit of the present invention.

Brief Description of the Drawings

Fig. 1 is a plane view schematically showing an example of a hot plate unit of the present invention.
Fig. 2 is a vertical cross-sectional view of the hot plate unit illustrated in Fig. 1.
Fig. 3 is a partially enlarged cross-sectional view showing a part of the ceramic substrate constituting the hot plate unit illustrated in Fig. 1.
In Fig. 4,(a) is a cross-sectional view schematically showing a hot plate unit in which an intermediate bottom plate is formed and (b) is a perspective view showing the bottom plate constituting the supporting case of the hot plate unit.
Fig. 5 is a cross-sectional view schematically showing a metal substrate equipped with a rubber heater.
Figs. 6 (a) to (d) are cross-sectional views schematically showing a part of the production process of a ceramic substrate constituting a hot plate unit.

Description of the Symbols

| | |
|---|---|
| 9 | a silicon wafer |
| 10 | a hot plate unit |
| 11, 211 | a ceramic substrate |
| 11a | heating face |
| 11b | bottom face |
| 12, 212 | a resistance heating element |
| 12a | a resistance heating element end portion |
| 14 | a bottomed hole |
| 15, 215 | a through hole |
| 16, 262 | a conductor wire |
| 17 | a washer |
| 18 | a heat-measuring element |
| 19 | a metal wire |
| 20 | a conductor-filled through hole |
| 21, 252 | a heat insulating ring |
| 22, 270 | a supporting case |
| 22a | a supporting case main body |
| 22b | a substrate-receiving part |
| 22c | a bottom plate-receiving part |
| 23 | a blind hole |
| 24, 260 | a bottom plate |
| 25 | a control unit |
| 26 | a power source unit |
| 27, 258 | a coolant introducing pipe |
| 28a, 28b | a through hole |
| 29 | a guide pipe |
| 49 | a lifter pin |
| 30 | a rubber heater |
| 31 | an aluminum disk plate |

| 32 | a heating element |
| 33 | a silicon rubber |
| 34 | a screw |
| 213 | a power feeding terminal |
| 218 | an insulating layer |
| 219 | a silicon wafer |
| 251 | a pin |
| 253 | a fixing metal member |
| 255 | a socket |
| 256 | an intermediate bottom plate |
| 256a | an opening |
| 257 | a sleeve |
| 258 | a coolant supply pipe |
| 259 | a supporting pin |
| 260a | an opening |
| 260k | a dent |

Disclosure of the Invention in Details

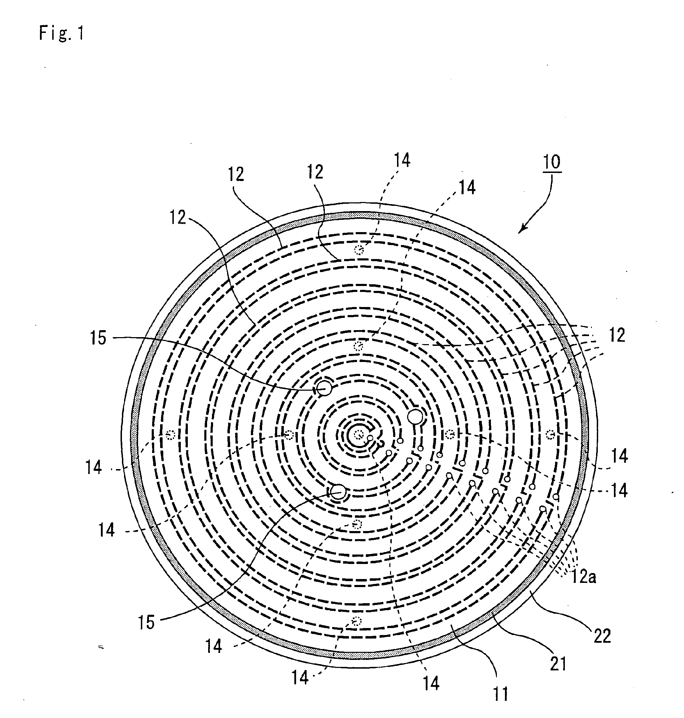

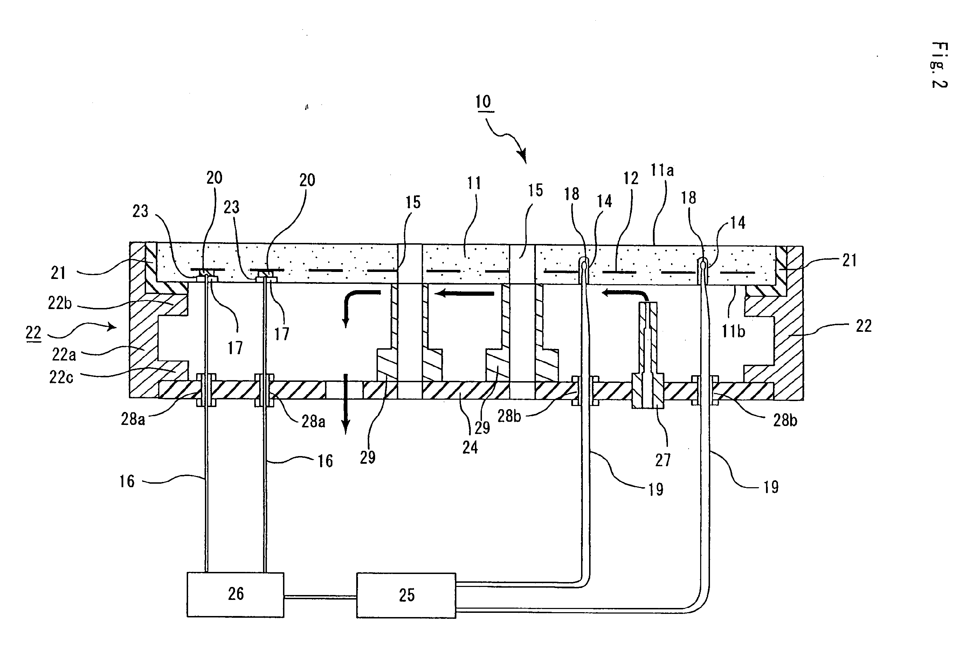

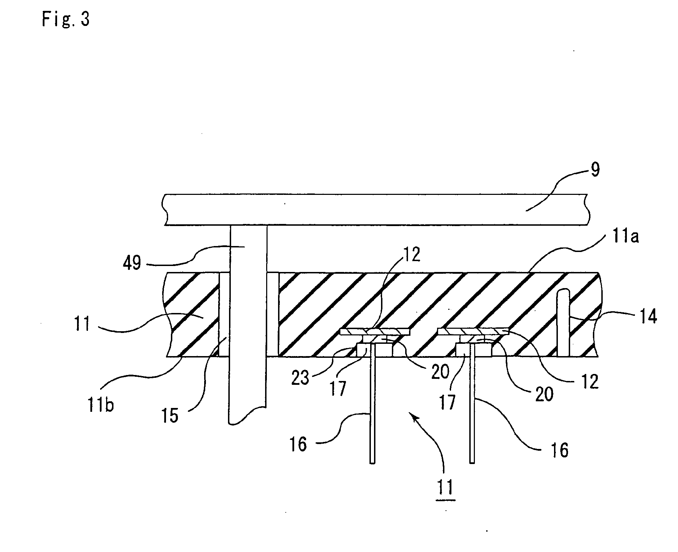

Fig. 1 is a plane view schematically showing one embodiment of a hot plate unit of the present invention: Fig. 2 is a cross-sectional view of the hot plate unit shown in Fig. 1: and Fig. 3 is a partially enlarged cross-sectional view of the ceramic substrate constituting the above-mentioned hot plate unit.

The ceramic substrate 11 is formed into a disk-like shape and, in the ceramic substrate 11 resistance heating elements 12 as temperature control means are formed in a concentric circles-like pattern. Further, these resistance heating elements 12 are connected in a manner that each of a pair of two adjacent concentric circles forms one line, as a set of circuit.

Further, since the resistance heating elements 12 are embedded in the ceramic substrate 11, blind holes 23 are formed immediately under the part where the end portions 12a of circuits, and washers 17 which are conductive buffering materials are fitted in the blind holes 23 and conductive wires 16 are inserted into center holes of the washers 17 and these washers 17 and conductive wires 16 are soldered, so that the end portions 12a of the resistance heating elements and the conductive wires 16 are connected with each other through the conductor-filled through holes 20. Incidentally, the washers 17 are installed as buffering materials in order to prevent the cracking that occurs attributed to the difference in the thermal expansion coefficient between conductive wires 16 and ceramic substrate 11 at the time when the materials to be conductive wires 16 are embedded directly in the ceramic substrate and thus, their thermal expansion coefficient is mean between the thermal expansion coefficients of both materials.

In Figs. 1 and 2, although the resistance heating elements 12 are embedded inside the ceramic substrate, the resistance heating elements may be formed on the bottom face of the ceramic substrate. In that case, a covering layer is preferably formed in order to protect the resistance heating elements. Further, in that case, the tip ends of conductive wires whose tip ends are formed to have a T-shape in the cross-sectional view may be connected and fixed by soldering and the like and led out of the through holes of the bottom plate 24.

Further, in the bottom face 11b of the ceramic substrate 11, a bottomed hole 14 is formed to insert the heat-measuring element such as a thermocouple, and a heat-measuring element 18 having two metal wires 19 is inserted into the bottomed hole 14 and fixedwith a heat-resistant insulationmaterial (not shown in the figure) such as silicon resin and the like.

Further, through holes 15 are formed in the ceramic substrate 11 and lifter pins 49 are inserted into the through holes 15 as shown in Fig. 3, so that a silicon wafer 9 can be held and the lifter pins 49 are moved up and down so as to: receive the silicon wafer 9 from a carrier machine; put the silicon wafer 9 on the heating face 11a of the ceramic substrate 11 to heat the silicon wafer in order to support the silicon wafer 9 at a distance of 50 to 2,000 μm from the heating face 11a to heat the silicon wafer. It should be noted that, as shown in Fig. 2, guide pipes 29 communicating with the through holes 15 are formed below the through holes 15 of the ceramic substrate 11 so as to make the lifter pins 49 pass through smoothly.

The ceramic substrate 11 with such a structure is fitted to the upper part of a generally cylindrical supporting case 22 through the heat insulating ring 21 and on the other hand, in the lower part of the supporting case 22, a bottom plate 24 for shielding heat is installed. Further, the conductive wires 16 connected to the resistance heating elements 12 and metal wires 19 connected to the heat-measuring element are led to the outside through the through holes 28a, 28b formed in the bottom plate 24.

It should be noted that, the conductive wires 16 are connected to a power source unit 26 of a control equipment and on the other hand, the metal wires 19 are connected to the control unit 25 of the control equipment.

Consequently, when electricity is applied to the conductive wires 16 connected to the power source unit 26, the resistance heating elements 12 inside the ceramic substrate 11 generate heat to heat the ceramic substrate 11 and thus an obj ect to be heated such as a silicon wafer and the like can be heated. At that time, the temperature of the ceramic substrate 11 is constantly monitored by the heat-measuring element 18 and based on the temperature data , voltage application instruction is given from the control unit 25 and according to the instruction from the control unit 25, proper voltage is applied from the power source unit 26.

Further, a coolant introducing pipe 27 is disposed in the bottom plate 24 and a coolant is made possible to be led into the inside of the supporting case 22 through the pipe which is not illustrated and the temperature and the introduction amount of the coolant are controlled so as to control the temperature dropping speed and the like after electricity application to the resistance heating elements 12 is stopped.

In the case of a hot plate unit shown in Fig. 1 to Fig. 3, the resistance heating elements are formed inside the ceramic substrate, but the heating elements may be formed on the surface (the bottom face)thereof (Examples 2 to 3). In this case, a coolant is directly brought into contact with the heating elements, rapid temperature drop can be achieved.

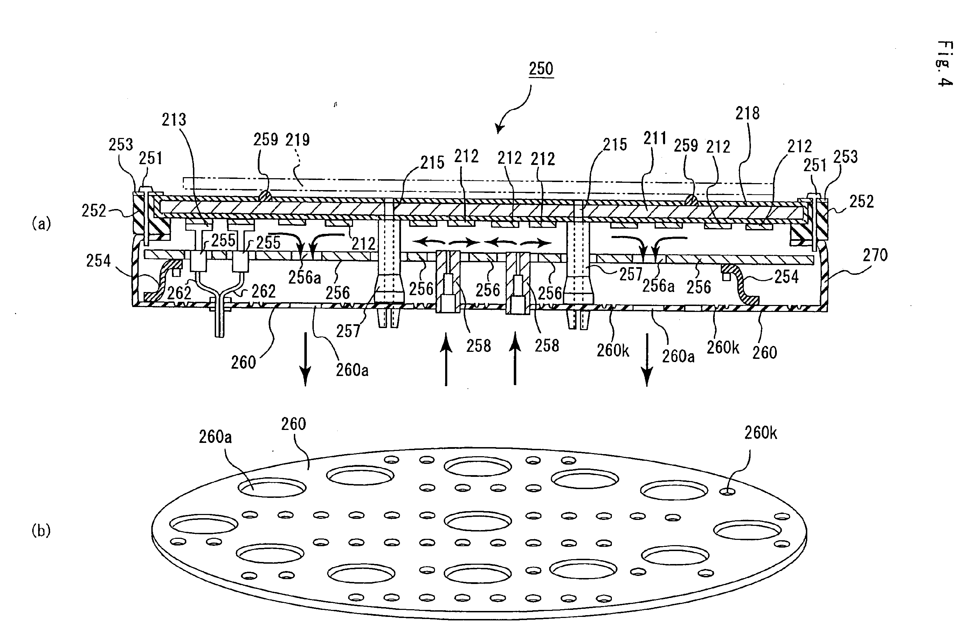

Further, fig. 4 (a) is a cross-sectional view, schematically showinga hotplate unit wherein resistance heating elements are formed on the bottom face of the ceramic substrate and further an intermediate bottom plate is disposed therein, and Fig. 4 (b) is a perspective view schematically showing the bottom plate constituting the supporting case of the hot plate unit.

In the figure, air as a coolant is circulated as far as the bottom plate 260, the thickness of the supporting case means the thickness from the bottom of the ceramic substrate to the bottom plate.

In this hot plate unit 250, an insulating film 218 is formed on the surface of a ceramic substrate 211 and supporting pins 259 are installed on the surface of the ceramic substrate 211 having the insulating film 218 to keep a silicon wafer 219 at a constant distance from the heating face of the ceramic substrate 211 thereof.

Further, resistance heating elements 212 are formed on the surface of the insulating film 218 of the ceramic substrate 211 and power feeding terminals 213 are connected to the end portions of the resistance heating elements 212. The power feeding terminals 213 are connected to a power source (not shown in the figure) through a socket 255 and conductive wires 262, so that heat can be generated from the resistance heating elements 212 by applying voltage through the conductive wires 262 and so on to heat the ceramic substrate 211. Further, although being not illustrated, a thermocouple (a heat-measuring element) for temperature control is buried in the ceramic substrate 211.

Further, the ceramic substrate 211 having the insulating film 218 is fitted in a heat insulating ring 252 disposed on the supporting case (a casing) 270 and the heat insulating ring 252 is fixed to the heat insulating ring 252 by pins 251 passing through the heat insulating ring 252, and on the other hand, the ceramic substrate 211 is fixed in the heat insulating ring 252 by the pins 251 and fixing metal members 253.

In the supporting case 270, a bottom plate 260 integrally formed in the supporting case 270 and openings 260a are formed and also a coolant supply pipe 258 is disposed. Further, sleeves 257 for protecting lifter pins to transport a silicon wafer to a carrier machine are formed in the supporting case.

Further, inside the supporting case 270, an intermediate bottom plate 256 supported by leaf springs 254 is installed and openings 256a are formed in the intermediate bottom plate. Further, as shown in Fig. 4(b), dents 260k are vertically and transversely formed just like a lattice in the bottom plate 260k. That such a large number of dents 260k are formed is because the strain of the bottom plate is corrected by these dents 260.

The thickness of the supporting case in the hot plate unit of the present invention (the thickness of the part where the coolant and the like is circulated) is 50 mm or less and which is thin. For that, the volume of the supporting case is small and the supply and discharge of the coolant can quickly be carried out and as a result, the excellent temperature-dropping property can be provided to control the temperature.

Further, by making the thickness of the supporting case thin, the thickness of the hot plate unit itself can also be thin, and thus the hot plate unit can be downsized and light inweight and even in case that it is incorporated into an equipment, enlargement of the equipment itself can be avoided.

The thickness of the ceramic substrate in the hot plate unit of the present invention is preferably 25 mm or less, and further preferably 10 mm or less.

That is because if the thickness of the ceramic substrate exceeds 25 mm, the heat capacity of the ceramic substrate increases and the temperature controlling property is deteriorated. It should be noted that, the thickness of the ceramic substrate is preferably a value exceeding 1.5 mm.

Further, in the present invention, the ratio of the thickness 1 of the above-mentioned substrate to the thickness L of the supporting case is preferably $0.02 \leqq 1/L$. Since the thickness L of the supporting case is thin when compared with the thickness 1 of the ceramic substrate, the heat-exchanged coolant such as air can be discharged quickly to make quick cooling possible.

If 1/L is lower than 0.02, that is, the thickness of the supporting case is too thick when compared with the thickness of the ceramic substrate, discharge of the coolant such as air which has carried out the heat exchange is retarded and the coolant accumulating heat such as air lingers in the supporting case, resulting in decrease of the cooling speed. Further, since the coolant lingers in the supporting case, the discharge amount disperses and as a result, the reproducibility of the cooling speed is deteriorated.

It is preferable for 1/L to be 10 or less (10 ≧ 1/L). If 1/L exceeds 10, the thickness 1 of the ceramic substrate is too thick when compared with the thickness L of the supporting case to result in large heat capacity. For that, the accumulated heat quantity of the ceramic substrate increases and the cooling speed is lowered. Further, the volume of the coolant to carry out contact heat exchange in relation to the stored heat quantity is decreased and the heat exchanging quantity disperses and as a result, the reproducibility of the cooling speed is deteriorated.

The diameter of the above-mentioned ceramic substrate is preferably 200 mm or larger, and is further preferably 12 inch (300 mm) or larger. That is because a silicon wafer with a large diameter, for example, 12 inch or larger will be a main stream of a semiconductor wafer of the next generation. Further, if the diameter of the ceramic substrate is small, the diameter of the supporting case is also small and the volume thereof becomes small and thus a hot plate unit is not so much required to be made thin.

The hot plate unit of the present invention is preferable to be used at 150°C or more, and most preferable to be used as 200 °C or more.

Next, the structures of the supporting case and the ceramic substrate and the like constituting the hot plate unit will be described further in details.

A supporting case 22 is generally made of a metal such as a SUS and the like from a viewpoint of easiness of processing and excellency in the mechanical properties.

As for the supporting case 22, a circular ring-like substrate-receiving part 22b is formed in the inner side of the upper part of the cylindrical main body 22a to support a ceramic substrate 11 and on the other hand, similarly a circular ring-like bottom plate-receiving part 22c is formed in the inner side of the lower part of the main body 22a to support a bottom plate 24 and the bottom plate 24 is fixed to the bottom plate-receiving part 22c by joining members such as volts and the like.

The material of the bottom plate 22 is not particularly restricted as far as it has: thermal conductivity which is not so high and enough to be excellent in the heat shielding property; and high heat resistance, and usable are, for example, heat-resistant resin, a ceramic plate, a composite plate containing heat-resistant organic fibers and inorganic fibers together with these materials, and the like.

Further, in the through holes 28a, 28b formed in the bottom plate, members capable of fixing conductive wires 16 and metal wires 19 which are passed through therein, to immobilize them may be disposed or the conductive wires 16 and the metal wires 19 may be passed through the through holes 28a, 28b as they are.

The heating substrate of the present invention is not particularly restricted and, it includes, for example, a ceramic substrate, a metal substrate, and the like.

As the metal substrate, usable is one or more kind of metals selected from aluminum, iron, stainless steel, and copper.

Resistance heating elements may be formed inside the metal substrate or on the surface thereof.

In the case of forming the resistance heating elements on the surface of the metal substrate, the surface of the resistance heating elements may be covered with an insulating material, and the resistance heating elements may be sandwiched between silicon rubbers and attached to one face of the metal plate by screws and the like.

Further, a channel may be formed inside the metal substrate and a heated oil or a coolant for cooling may be circulated in the channel.

The following description describes the case of using a ceramic substrate.

The ceramic material constituting the ceramic substrate of the present invention is not particularly restricted and usable are, for example, a nitride ceramic, a carbide ceramic, an oxide ceramic and the like.

Examples of the above-mentioned nitride ceramic are metal nitride ceramics such as aluminum nitride, siliconnitride, boron nitride and the like.

Further, examples of the above-mentioned carbide ceramic are metal carbide ceramics such as silicon carbide, zirconium carbide, tantalum carbide, tungsten carbide and the like.

Examples of the above-mentioned oxide ceramic are metal oxide ceramics such as alumina, zirconia, cordierite, mullite and the like.

These ceramics may be used solely or in combination of two or more of them.

Among these ceramics, nitride ceramics and oxide ceramics are preferable.

Further, aluminum nitride is most preferable among the nitride ceramics. That is because the thermal conductivity is highest, 180 W/m·K.

In the ceramic substrate of the present invention, it is preferable that the pore diameter of the maximum pores is 50 μm or less and the porosity is preferable 5% or less. Further, the above-mentioned ceramic substrate is preferable either having no pore at all or if pore exists, the pore diameter of the maximum pores is preferable 50 μm or less.

If there is no pore exist, the breakdown voltage at a high temperature is particularly high and to the contrary, if there are pores to a certain extent, the fracture toughness is particularly high. Hence, which design to be selected is changed depends on the required properties.

Although it is not so clear why the fracture toughness becomes high depending on the existence of the pores, it is supposedly attributed to the stop of the expansion of cracks by pores.

The reason why the pore diameter of the maximum pores is preferable to be 50 μm or less in the present invention is because if the pore diameter exceeds 50 μm, the high breakdown voltage property becomes hard to be kept especially at 200 °C.

The pore diameter of the maximum pores is preferably 10 μm or less. That is because the amount of the warp becomes low at 200 °C or more.

The porosity and the pore diameter of the maximum pore can be adjusted by the pressurizing duration, the pressure, the temperature, and the additives such as SiC and BN at the time of sintering. As described above, SiC and BN can inhibit sintering so that pores can be introduced.

At the time of measuring the pore diameter of the maximum pore, five samples are made ready and the surface of each specimen is polished into a mirror plane and photographed at 10 points with 2,000 to 5,000 magnifications by an electron microscope. Then, the maximum pore diameters are selected from the photographs obtained by the photographing, and the average of the 50 shots is defined as the pore diameter of the maximum pore.

The porosity is measured by Archimedes' method. That is, a sintered body is pulverized and the pulverized product is put in mercury to measure the volume thereof, and the true specific gravity is calculated from the weight of the pulverized product and the volume thereof, and the porosity is calculated from the true specific gravity and the apparent specific gravity.

The above-mentioned ceramic substrate is preferable to contain 0.05 to 10 % by weight of oxygen. That is because segregation of oxygen in grain boundaries can improve the fracture toughness value.

That is because, if the oxygen content is below 0.05 % by weight, sintering cannot proceeds and the porosity becomes high and the thermal conductivity is decreased, whereas, if the oxygen content exceeds 10 % by weight, the amount of oxygen in the grain boundaries is too much and therefore the thermal conductivity drops and the temperature-rising and falling property are deteriorated.

In order to incorporate oxygen to the above-mentioned ceramic substrate, a metal oxide is mixed with raw material powders to be subjected to firing.

As the above-mentioned metal oxide, examples are yttria ($Y_2O_3$) , alumina ($Al_2O_3$) , rubidium oxide ($Rb_2O$) , lithium oxide ($Li_2O$) , calcium carbonate ($CaCO_3$) and the like.

The addition amounts of these metal oxides are preferably 0.1 to 20 parts by weight to 100 parts by weight of a nitride ceramic.

In the present invention, the ceramic substrate is desirable to contain 5 to 5,000 ppm of carbon.

That is because addition of carbon blackens the ceramic substrate and the radiation heat can efficiently be utilized at the time of using the ceramic substrate as a heater.

The carbon may be amorphous or crystalline. That is because, in the case of using an amorphous carbon, the drop of the volume resistivity at a high temperature can be prevented and in the case of using a crystalline one, the drop of thermal conductivity at a high temperature can be prevented. Consequently, depending on the use purposes, both of the crystalline carbon and the amorphous carbon may be used together. Further, the content of the carbon is more preferably 50 to 2 , 000 ppm.

In the case of incorporating carbon to a ceramic substrate, it is preferable to add carbon so as to control the brightness to be N6 or less as the value defined by the standard of JIS Z 8721. That is because those having brightness in such a degree are excellent in the radiation heat quantity and the covering-up property.

The brightness N represents a brightness scale with the brightness of ideal black being taken as 0 and the brightness of ideal white as 10 and the brightness of a sample is expressed on the scale divided in 10 at equal intensity intervals of perceptual brightness, as N0 to N10.

In actual measurement, a comparison is made with color cards corresponding to N0 to N10. In this case, decimal fractions are rounded to 0 or 5.

In case that the resistance heating elements are formed inside the ceramic substrate, they may be formed in a plurality of layers. In such a case, it is preferable to form the patterns of respective layers so as to complement one another and to form the patterns seen in any one of the layers when being observed from the heating face. For example, a structure having a staggered arrangement may be used.

The resistance heating elements are preferably made of metals such as noble metals (gold, silver, platinum, palladium) , lead, tungsten, molybdenum, nickel and the like, or conductive ceramics such as carbides of tungsten or molybdenum. That is because the resistance value can be heightened and the thickness itself can be made thick for the purpose to prevent disconnection and at the same time those metals are hard to be oxidized and their thermal conductivity is hard to drop. They may be used solely or in combination of two or more of them.

Further, since the resistance heating elements are required to keep the temperature of the whole of a ceramic substrate even, preferable are a concentric circles-like pattern as shown in Fig. 1, or the combination of a concentric-like pattern and a winding pattern. The thickness of the resistance heating elements is preferably 1 to 50 µm and the width is preferably 5 to 20 mm.

Although the resistance values can be changed by changing the thickness and the width of the resistance heating elements, the above-mentioned ranges are most practical. The resistance value of each resistance heating element increases more as the element becomes thinner in the thickness and smaller in the width.

It shouldbe noted that, in case that the resistance heating elements are disposed inside, the distance between the heating face and the resistance heating elements becomes short and the evenness of the temperature of the surface is deteriorated and therefore, the width of the resistance heating elements has to be widened. Further, since the resistance heating elements are formed inside the ceramic substrate, it becomes unnecessary to consider the close adhesion to the ceramic substrate.

The section of resistance heating element may be either of a rectanglar, an elliptic, a spindle-like and a semicircular shape, but is desirably flat. This is because since a flat one tend to radiate heat toward the heating face, a large calorific value can be transmitted to the heating face and a temperature distribution in the heating face is not easily generated. The shape of the resistance heating element may be spiral.

At the time of forming the resistance heating elements inside the ceramic substrate, it is preferable to form the resistance heating elements within a range of 60 % in the thickness direction from the bottom face. That is because the temperature distribution in the heating face can be eliminated and a semiconductor wafer can evenly be heated.

In order to form resistance heating elements on the bottom face or inside the above-mentioned ceramic substrate, it is preferable to use a conductor containingpaste comprisingametal and a conductive ceramic.

That is, in case that resistance heating elements are formed on the bottom face of a ceramic substrate, generally, after a ceramic substrate is produced by firing, the above-mentioned conductor containing paste layer is formed on the surface and fired to form the resistance heating elements.

On the other hand, as shown in Fig. 1 and Fig. 2, in case that the resistance heating elements 12 are formed inside the ceramic substrate 11, after the above-mentioned conductor containing paste layer is formed on a green sheet, the resulting green sheet is pressurized and heated together with other green sheets to be integrated and to produce a lamination of the green sheets. After that, the lamination is fired to form the resistance heating elements inside the ceramic substrate.

The above-mentioned conductor containing paste is not particularly restricted, however preferable are those containing metal particles and conductive ceramic particles to keep conductivity and additionally, resin, a solvent, a thickening agent and the like.

Examples of the material of the above-mentioned metal particles and the conductive ceramic particles are as described above. The particle diameter of these metal particles or conductive ceramic particles is preferably 0.1 to 100 µm. That is because if the diameter is too thin, below 0.1 µm, oxidation easily takes place and on the other hand, and if it exceeds 100 µm, sintering becomes difficult and the resistance value increases.

The shape of the above-mentioned metal particles may be spherical or scaly. In the case of using such metal particles, a mixture of spherical and scaly ones may be used.

In case that the above-mentioned metal particles are mixture of the spherical one and the scaly one, metal oxides are easy to be retained among metal particles and the adhesion between the resistance heating elements and the ceramic substrate is made reliable and the resistance value can be increased and for that, it is advantageous.

As the resin to be used for above-mentioned paste, examples are acrylic resin, epoxy resin, phenol resin and the like. Further, as the solvent, examples are isopropyl alcohol and the like. As the thickening agent, examples are cellulose and the like.

When a conductor containing paste for resistance heating elements is formed on the surface of the ceramic substrate, it is preferable to add a metal oxide to the conductor containing paste besides the above-mentioned metal particles to sinter the above-mentioned metal particles and the above-mentioned metal oxides. In such a manner, by sintering the metal oxide together with the metal particles, the ceramic substrate and the metal particles are further closely adhered to each other.

The reason why the close adhesion property to the ceramic substrate is improved is not clear, however it is supposedly attributed to that oxide films are formed on the surface of the metal particle or the surface of a ceramic substrate comprising non-oxide is slightly oxidized and the oxide films are integrated through the metal oxides by sintering to closely stick the metal particles and the ceramic. Further, in case that the ceramic used for the ceramic substrate is an oxide, the surface naturally comprises an oxide, so that a conductive layer excellent in the adhesion strength is formed.

The above-mentioned metal oxide is preferably at least one of oxides selected from, for example, lead oxide, zinc oxide, silica, boron oxide ($B_2O_3$), alumina, yttria, and titania.

That is because these oxides can improve the adhesion strength between the metal particles and the ceramic substrate withoutincreasingtheresistancevalueoftheresistanceheating elements.

When the total amount of the metal oxides is set to 100 parts by weight, the weight ratio of lead oxide, zinc oxide, silica, boron oxide ($B_2O_3$), alumina, yttria and titania is as follows: lead oxide: 1 to 10, silica: 1 to 30, boron oxide: 5 to 50, zinc oxide: 20 to 70, alumina: 1 to 10, yttria: 1 to 50 and titania: 1 to 50. The ratio is preferably adjusted within the scope that the total thereof is not over 100 parts by weight.

By adjusting the amounts of those oxides within the respective ranges, especially, the adhesion strength to the ceramic substrate can be improved.

The addition amount of the above-mentioned metal oxides to the metal particles is preferably 0.1 % by weight or more and below 10 % by weight. Further, the area resistivity is preferably 1 to 45 mΩ/□ if the resistance heating elements are formed using a conductor containing paste with such constitutions.

If the area resistivity exceeds 45mΩ/□, the heat radiation amount becomes so high for the applied voltage quantity to make the heat radiation amount difficult to be controlled in the case of a ceramic substrate having the resistance heating elements on the surface for a semiconductor device. Incidentally, if the addition amount of the metal oxides is 10 % by weight or more, the area resistivity exceeds 50 mΩ/□, the heat radiation amount becomes so high for the applied voltage quantity to make the heat radiation amount difficult to be controlled and the evenness of the temperature distribution is deteriorated.

If the resistance heating elements are formed in the surface of a ceramic substrate, a metal covering layer is preferable to be formed on the surface of the resistance heating elements. That is because the change of resistance value owing to the oxidation of the metal sintered body can be prevented. The metal covering layer to be formed is preferable to be 0.1 to 10 μm.

Any non-oxidizable metal may be used as the metal for the above-mentioned metal covering layer formation without any restriction and practically, examples are gold, silver, palladium, platinum, nickel and the like. Theymay be used solely or in combination of two or more of them. Among them, nickel is preferable.

In case that the resistance heating elements are formed inside a ceramic substrate, since the resistance heating elements are prevented from oxidation, the covering is unnecessary.

The size of the connecting portions of metal wires of a thermocouple to be buried in bottomed holes of the above-mentioned ceramic substrate is equal to the diameter of the strand wire of each metal wire or larger than that and 0.5 mm or less. With such a constitution, the heat capacity of the connecting portions is lowered and the temperature is precisely and quickly converted to the electric current value. For that, the temperature controllability is improved and the temperature distribution of the heating face of the wafer becomes small.

Examples of the above-mentioned thermocouple are K-type, R-type, B-type, S-type, E-type, J-type, and T-type thermocouples as listed up in JIS-C-1602 (1980).

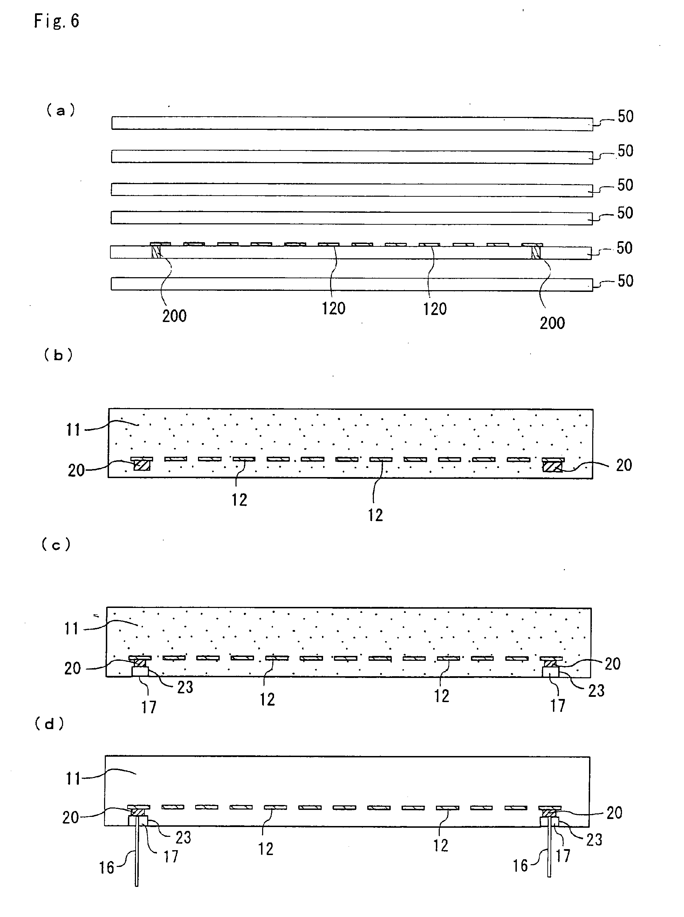

Next, one example of the production method of a ceramic substrate constituting a hot plate unit of the present invention will be described according to the cross-sectional views of Fig. 6(a) to (d) and further, a method for assembling a hot plate unit using the ceramic substrate will briefly be described.

(1) At first, a green sheet 50 is obtained by mixing a powder of a ceramic such as a nitride ceramic, a carbide ceramic and the like with a binder and a solvent.

As the ceramic powder, usable are, for example, an aluminum nitride powder, a silicon nitride powder and the like. Further, an assisting agent such as yttria may be added.

Further, as the binder, desirable to be used is at least one of binders selected from an acrylic binder, ethyl cellulose, butyl cellosolve, and poly vinyl alcohol.

Further, as the solvent, desirable to be used is at least one of solvents selected from α-terpineol and glycol.

The green sheet 50 is produced by forming a paste obtained by mixing those materials into a sheet-like shape by a doctor blade method.

Based on necessity, the following may be formed in the green sheet 50; through holes to insert supporting pins for a silicon wafer, concaved parts to embed a thermocouple, and through holes at points where conductor-filled through holes are to be formed. The through holes may be formed by punching.

The thickness of the green sheet 50 is preferably about 0.1 to 5 mm.

Next, the through holes are filled with a conductor containing paste to obtain a through hole printed body 200 and then a conductor containing paste to be resistance heating elements is printed on the green sheet 50.

The printing is so carried out as to obtain a desired aspect ratio while taking the shrinkage ratio of the green sheet 50 into consideration to obtain the resistance heating element layer-printed body 120.

The printed body is formed by printing a conductor containing paste containing a conductive ceramic, metal particles and the like.

As the conductive ceramic particles contained in the conductor containing paste, most suitable are carbides of tungsten or molybdenum. Because they are hard to be oxidized and the thermal conductivity is hard to drop.

Further, as metal particles, usable are, for example, tungsten, molybdenum, platinum, nickel and the like.

The average particle diameter of the conductive ceramic particles and the metal particles is preferably 0.1 to 5 μm. This is because the paste for a conductor is difficult to be printed if the particles are too large or too small.

As such a paste, the optimum one is a conductor containing paste produced by mixing 85 to 97 parts by weight of metal particles or conductive ceramic particles, 1.5 to 10 parts by weight of at least one binder selected from an acrylic type binder, ethyl cellulose, butyl cellosolve, and poly vinyl alcohol, and 1.5 to 10 parts by weight of at least one solvent selected from α-terpineol, glycol, ethyl alcohol and butanol.

(2) Next, as shown in Fig. 6 (a) , a green sheet 50 having printed bodies 200, 120 and a green sheet 50 having no printed body are laminated. The reason why the green sheet 50 having no printed body is laminated on the resistance heating element formation side is because the end faces of conductor-filled through holes can be prevented from oxidation at the time of firing in the resistance heating element formation even if the end faces are exposed. If firing for the resistance heating element formation is carried out while the end faces of the conductor-filled through holes being fired, a metal such as nickels, which is hardly oxidized is required to be sputtered and further preferably, a gold solder of Au-Ni may be used for covering.

(3) Next, as shown in Fig. 6 (b) , the lamination is heated and pressurized to form a lamination of green sheets.

After that, the green sheets and the conductor containing paste are sintered. The temperature of the firing is preferably 1,700 to 2,000 °C and the pressure of pressurizing at the time of the firing is preferably 10 to 20 MPa. The heating and pressurizing step is carried out in an inert gas atmosphere. As the inert gas, usable are argon, nitrogen and the like. In the firing step, a through hole 20 and resistance heating elements 12 are formed.

(4) Next, as shown in Fig. 6 (c) , blind holes 23 are formed for external terminal connection and washers 17 are fitted in the blind holes 23. The washers 17 have thermal expansion coefficient between those of the ceramic substrate 11 and the conductive wires 16, function as a buffering material, and are preferable to be conductive.

(5) Finally, as shown in Fig. 6 (d) , the conductive wires 16 are inserted into the center holes of the washers 17, and the washers 17 and the conductive wires 16 are attached to the ceramic substrate 11 by soldering, brazing and the like and at the same time the conducive wires 16 are connected to the resistance heating elements 12 through the conductor-filled through holes 20.

As the solder, alloys of silver-lead, lead-tin, bismuth-tin and the like may be used. It should be noted that, the thickness of the solder layer is preferably 0.1 to 50 μm. Because it is a sufficient range to form reliable connection by the solder.

(6) Further, a bottomed hole 14 as shown in Fig. 2 is formed on the bottom face of the ceramic substrate 11 and a heat-measuring element 18 such as a thermocouple is inserted into the inside and fixed with a heat resistant insulation member of such as silicone resin to complete the production of the ceramic substrate 11 having the resistance heating elements 12.

(7) Next, the obtained ceramic substrate 11 is fitted to a supporting case 22 with the structure shown in Fig. 2 through a heat insulating ring 21 and the conductive wires 16 and the metal wires 19 are withdrawn from the through holes 28a, 28b in a bottom plate 24 to complete the assembly of the hot plate unit.

It should be noted that, the production of the ceramic substrate in which the resistance heating elements 12 are embedded is mainly described in the above description, and at the time of producing the ceramic plate in which the resistance heating elements are formed on the bottom face, after the supporting case is produced, a conductor containing paste is printed on the bottom face of the ceramic substrate and fired to form the resistance heating elements as described above and after that, the metal covering layer may be formed by electroless plating and the like.

In the production method of the above-mentioned ceramic substrate, the resistance heating elements are formed inside the ceramic substrate using green sheets, however, the ceramic substrate may be produced by: producing a granular powder using a ceramic powder, a binder and the like; being followed by producinga formed body by conductingpress-formingafter filling a molding die with the resulting powder; and then firing the formed body. In this case, metal wires and the like are buried inside the molding die to form resistance heating elements. Also, the resistance heating elements may be formed on the bottom face by the above-mentioned method after the ceramic substrate is produced.

Although the hot plate unit is described above, it may become an electrostatic chuck by forming resistance heating elements on the surface or inside of the ceramic substrate and installing electrostatic electrodes inside the ceramic substrate.

Further, it may become wafer prober by forming resistance heating elements on the bottom face or inside of the ceramic substrate and installing a guard electrode and a ground electrode inside the ceramic substrate.

Best Mode for Carrying out the Invention

Hereinafter, the invention will be described in more details.

(Example 1) Production of a hot plate unit

(1) A green sheet with the thickness of 0.47 mm was obtained using a paste containing 100 parts by weight of an aluminum nitride powder (the average particle diameter 1.1 $\mu$m, produced by Tokuyama Corporation) , 4 parts by weight of yttria (the average particle diameter 0.4 $\mu$m) , 11.5 parts by weight of an acrylic binder, 0.5 parts by weight of a dispersant, and 53 parts by weight of alcohol comprising 1-butanol and ethanol by forming the paste into a sheet like shape by a doctor blade method.

(2) Next, after the green sheet is dried at 80 °C for 5 hours, through holes with the diameters of 1.8 mm, 3.0 mm, and 5.0 mm are respectively formed. These through holes were parts to be through holes to insert supporting pins for supporting a silicon wafer into, parts to be conductor-filled through holes, and the like.

(3) A conductor containing paste A was produced by mixing 100 parts by weight of a tungsten carbide particle (the average particle diameter 1 $\mu$m) , 3.0 parts by weight of an acrylic binder, 3.5 parts by weight of $\alpha$-terpineol solvent, and 0.3 parts by weight of a dispersant.

A conductor containing paste B was produced by mixing 100 parts by weight of a tungsten particle (the average particle diameter 3 $\mu$m), 1.9 parts by weight of an acrylic binder, 3.7 parts by weight of $\alpha$-terpineol solvent, and 0.2 parts by weight of a dispersant.

The conductor containing paste A was printed on the green sheet by screen printing to form a conductor containing paste layer for heating elements. The printed patterns were made to be concentric circles-like patterns as shown in Fig. 1. The conductor containing paste B was filled in the through hole parts to be conductor-filled through holes.

Thirty seven green sheets on which no conductor containing paste was printed were stacked on the upper side (heating surface) of the green sheet subjected to the above-mentioned treatment, and 13 green sheets on which no conductor containing paste was printed were stacked on the lower side thereof, and then the green sheets were laminated at 130 °C and a pressure of 8 MPa to form a lamination.

(4) Next, the obtained lamination was degreased at 600 °C for 5 hours in nitrogen gas, hot-pressed at 1890°C and 15 MPa pressure for 10 hours to obtain an aluminum nitride plate-like body with the thickness of 3 mm. The obtained body was cut into a plate-like body with a circular shape of 310 mm comprising heating elements with the thickness of 6 $\mu$m and the width of 10 mm inside.

It should be noted that, the size of the conductor-filled through holes were 0.2 mm in the diameter and 0.2 mm in the thickness.

(5) Next, after the plate-like body obtained in the above description (4) was ground by a diamond grinder, a mask was put on and bottomed holes 14 for thermocouples were formed in the surface by blast treatment with SiC and the like.

(6) Further, blind holes 23 with the diameter of 5 mm and the depth of 0.5 mm were formed by drilling and washers 17 made of W were fitted in the blind holes 23 and after conductive wires 16 were inserted into the center holes of the washers 17, the washers 17 and the conductive wires 16 were fixed to the ceramic substrate by using a gold solder of a Ni-Au alloy (Au: 81.5 % by weight, Ni: 18.4 % by weight, and impurities : 0.1 % by weight) and reflowing the solder by heating at 970 °C.

(7) Next, a plurality of thermocouples, heat-measuring elements 18, were buried in the bottomed holes 14 to complete the manufacture of the ceramic substrate in which the resistance heating elements 12 were buried.

(8) Next, the ceramic substrate 11 was fitted to a supporting case 22 with the thickness of 25 mm, as shown in Fig. 2, through a heat insulating ring 21 and the conductive wires 16 and the metal wires 19 were withdrawn from the through holes 28a, 28b and connected to a power source unit 26 and a control unit 25 to obtain a hot plate unit 10.

(Example 2)

(1) A granular powder was produced by spray drying a composition containing 100 parts by weight of an aluminumnitride powder (the average particle diameter 1.1 µm) , 4 parts by weight of yttria (the average particle diameter 0.4 µm) , 12 parts by weight of an acrylic binder and alcohol.
(2) Next, after the powder was put in a die and molded in a flat plate form to obtain a raw formed body (green).
(3) The processed raw formed body was hot pressed at 1,800 °C and 20 MPa pressure to obtain an aluminum nitride plate-like body with the thickness of 3 mm. The obtained plate-like body was cut into a ceramic substrate with a circular shape of 310 mm in diameter and the resulting ceramic substrate is drilled to form parts to be through holes 15 to insert supporting pins for a silicon wafer and parts to be conductor-filled through holes 14 (the diameter: 1.1 mm, the depth:2 mm).
(4) To the ceramic substrate processed as described in description (3), a conductor containing paste was printed by screen printing. The printed patterns were formed to be concentric circles-like patterns as shown in Fig. 1.

As the conductor containing paste, used was Solbest PS603D, which is conventionally used for conductor-filled through hole formation for a printed circuit board, produced by Tokuriki Kagaku Kenkyu-zyo.
The conductor containing paste was a silver-lead paste and contained 100 parts by weight of silver and 7.5 parts by weight of metal oxides comprising lead oxide (5 % by weight), zinc oxide (55 % by weight) , silica (10 % by weight) , boron oxide (25 % by weight), and alumina (5 % by weight). The silver particles had the average particle diameter of 4. 5 µm and were scaly.

(5) Then, the ceramic substrate 11 on which the conductor containing paste was printed was heated at 780 °C to sinter silver and lead in the conductor containing paste and at the same time bake the paste on the ceramic substrate 11 and form resistance heating elements 12. The heating elements of silver-lead had the thickness of 5 µm, the width of 2 . 4 mm, and the area resistivity of 7.7 mΩ/□
(6) The ceramic substrate 11 produced as described in the description (5) was immersed in an electroless nickel plating bath comprising an aqueous solution containing 80 g/l of nickel sulfate, 24 g/l of sodiumhypophosphite, 12 g/l of sodiumacetate, 8 g/l of boric acid, and 6 g/l of ammonium chloride to precipitate a metal covering layer (a nickel layer) with the thickness of 1 µm on the surface of the silver-lead heating elements.
(7) To the parts to which conductive wires were to be attached to reliably form connection to a power source, a silver-lead solder paste (produced by Tanaka Kikinzoku Kogyo CO.) was printed to form a solder layer and then electric wires having T-shaped cross-sectional views in the tip end parts were disposed on the solder layer and heated at 420 °C for heating and reflowing of the solder to be attached to the surface of the resistance heating elements.
(8) The thermocouples, heat-measuring elements, were sealed with polyimide to obtain a ceramic substrate having the resistance heating elements on the bottom face.
(9) Then, the obtained ceramic substrate was fitted to a supporting case 22 with the thickness of 15 mm, as shown in Fig. 2 through a heat insulating ring 21, and the conductive wires 16 and the metal wires 19 were withdrawn from the through holes 28a, 28b and connected to a power source unit 26 and a control unit 25 to obtain a hot plate unit.

(Example 3)

A hot plate unit was manufactured in the same manner as the example 2, except that a supporting case with the thickness of 40 mm was used.

(Example 4)

A supporting case in which an intermediate bottom plate was disposed as shown in Fig. 4 was used. The thickness of the supporting case was 20 mm, which was the distance between the bottomplate thereof and the bottom face of the ceramic substrate. The thickness of the ceramic substrate was 3 mm. A hot plate unit was manufactured in the same manner as the example 2, except those described above.

(Example 5)

A hot plate unit was manufactured in the same manner as the example 2, except that a supporting case with the thickness of 50 mm was used and the thickness of the ceramic substrate was adjusted to be 0.5 mm.

(Example 6)

A hot plate unit was manufactured in the same manner as the example 2, except that a supporting case with the thickness of 5 mm was used and the thickness of the ceramic substrate was adjusted to be 60 mm. In this case, the ceramic substrate was directly fixed in the supporting substrate with screws.

(Example 7)

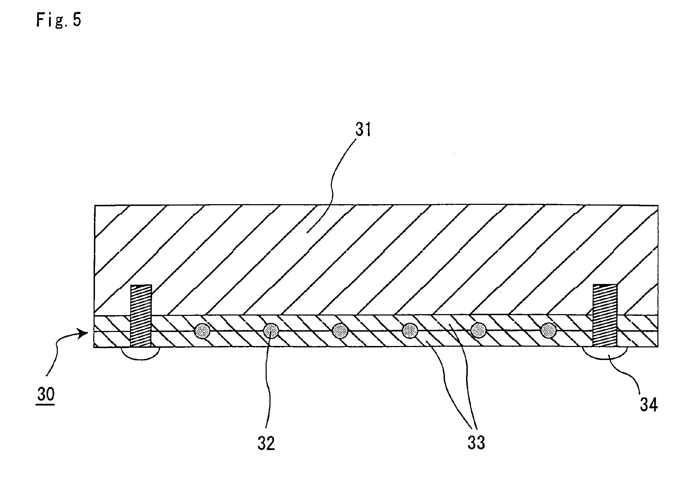

As shown in Fig. 5, a heating substrate was manufactured by fixing a rubber heater 30 which was composed of a heating element 32 comprising a Nichrome wire and two silicon rubber sheets 33 sandwiching the heating element 32 between them, with a screw 34, on one face of an aluminum disk 31 with the thickness of 15 mm and the diameter of 310 mm.
The heating substrate with such a structure was fitted in a heat insulating ring of a supporting case in which an intermediate bottom plate was disposed as shown in Fig. 4 to obtain a hot plate unit. The thickness of the supporting case was 15 mm, which was the distance between the bottom plate and the bottom face of the ceramic substrate.

(Example 8)

A hot plate unit was manufactured in the same manner as the example 2, except that a supporting case with the thickness of 5 mm was used and the thickness of the ceramic substrate was adjusted to be 30 mm.

(Comparative example 1)

A hot plate unit was manufactured in the same manner as the example 2, except that the supporting case with the thickness of 55 mm was used.

(Comparative example 2)

A hot plate unit was manufactured in the same manner as the example 7, except that the thickness was adjusted to be 55 mm, which was the distance between the bottom plate and the bottom face of the ceramic substrate.
The hot plate units produced according to the examples 1 to 8 and comparative examples 1 to 2 were heated to 200 °C and then cooled to 150 °C by supplying air. Evaluation methods

(1) Measurement of temperature-dropping time

The time taken to drop the temperature of each hot plate unit from 200 °C to 150 °C was measured 10 times and the average value of the results of 10 time measurements was defined as the temperature-dropping time.

(2) Dispersion of temperature-dropping time

The temperature-dropping time was measured by the above-mentioned method (1) and the dispersion of the temperature-dropping time for 10 time measurements was calculated according to the following equation (1).

$$\text{Dispersion of temperature-dropping time (\%)} = [(\text{the longest time - the shortest time}) / \text{average time}] \times 100 \qquad (1).$$

Table 1

| | thickness of the supporting case (mm) | substrate thickness 1/case thickness L | temperaturedropping time (min) | dispersion of temperature-dropping time (%) |
|---|---|---|---|---|
| Example 1 | 25 | 0.12 | 5 | 1 |

Table 1   (continued)

| | thickness of the supporting case (mm) | substrate thickness 1/case thickness L | temperaturedropping time (min) | dispersion of temperature-dropping time (%) |
|---|---|---|---|---|
| Example 2 | 15 | 0.2 | 2 | 1 |
| Example 3 | 40 | 0.08 | 3 | 1 |
| Example 4 | 20 | 0.15 | 2 | 1 |
| Example 5 | 50 | 0.01 | 8 | 5 |
| Example 6 | 5 | 12.00 | 8 | 5 |
| Example 7 | 15 | 1.00 | 10 | 3 |
| Example 8 | 5 | 6.00 | 5 | 1 |
| Camparative example 1 | 55 | 0.06 | 10 | 3 |
| Comparative example 2 | 55 | 0.27 | 20 | 3 |

As being made clear from the results shown in Table 1, temperature can quickly be dropped and the dispersion of the temperature-dropping time can become small by making the thickness L of a case thin and the ratio of (the thickness of a substrate: 1)/(the thickness of a case:L) be 0.02 or more.

Industrial Applicability

As described above, a hot plate unit of the present invention is a thin type and comprises a supporting case with a small volume, so that temperature-rising and temperature-falling can be carried out sufficiently quickly even if the diameter of a substrate becomes large and further owing to the thin-size thereof and the lightness in weight, the apparatus can be downsized.

**Claims**

1.   A hot plate unit comprising a supporting case and a ceramic substrate equipped with a resistance heating element composed of one or more circuit (s) ; said ceramic substrate being fitted to said supporting case,
     wherein the thickness of said supporting case is 50 mm or less.

2.   The hot plate unit according to claim 1,
     wherein the ratio of the thickness 1 of said substrate to the thickness L of said supporting case satisfies $0.02 \leqq 1/L$.

3.   The hot plate unit according to claim 1 or 2,
     wherein:

     said supporting case is equipped with a bottom plate in the lower part; and
     a conductive wire connected to an end portion of said resistance heating element and/or a wiring led out of a heat-measuring element installed in said ceramic substrate are/is withdrawn from a through hole formed in said bottom plate.

4.   The hot plate unit according to claim 3,
     wherein a coolant introducing pipe is disposed in said bottom plate.

Fig. 1

Fig. 2

Fig. 3

Fig. 4

(a)

(b)

Fig. 5

Fig. 6

(a)

```
                                                    50
                                                    50
                                                    50
                                                    50
                                                    50
                                                    50
```

200          120          120          200

(b)

11
20                                                        20
12
12

(c)

11
20                                                        20
17    23          12          12          17    23

(d)

11
20                                                        20
16    23    17    12          12    16    17    23

**European Patent Office**

## EUROPEAN SEARCH REPORT

Application Number

EP 04 01 3360

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | PATENT ABSTRACTS OF JAPAN vol. 1999, no. 13, 30 November 1999 (1999-11-30) -& JP 11 224127 A (KOMATSU LTD), 17 August 1999 (1999-08-17) * abstract; figure * * paragraph [0021] * ----- | 1,3,4 | H05B3/68 H05B3/20 H01L21/027 H05B3/14 |
| A | PATENT ABSTRACTS OF JAPAN vol. 1997, no. 12, 25 December 1997 (1997-12-25) -& JP 09 213465 A (SHARP CORP), 15 August 1997 (1997-08-15) * abstract; figure 1 * ----- | 1-4 | |
| A | WO 99/49101 A (MATTSON TECH INC) 30 September 1999 (1999-09-30) * figures 4B,4C,4E * ----- | 1-4 | |
| A | PATENT ABSTRACTS OF JAPAN vol. 1999, no. 01, 29 January 1999 (1999-01-29) -& JP 10 284382 A (KOMATSU LTD), 23 October 1998 (1998-10-23) * abstract; figure 1 * ----- | 1-4 | TECHNICAL FIELDS SEARCHED (Int.Cl.7) H05B H01L |
| A | WO 99/18602 A (APPLIED MATERIALS INC) 15 April 1999 (1999-04-15) * page 6, lines 6-10,20-28; figure 1 * ----- | 1-4 | |
| A | US 5 616 024 A (NOBORI KAZUHIRO ET AL) 1 April 1997 (1997-04-01) * figures 1,15 * ----- | 1-4 | |

The present search report has been drawn up for all claims

| Place of search | Date of completion of the search | Examiner |
|---|---|---|
| Munich | 29 July 2004 | Gea Haupt, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 463 382 A1**

## ANNEX TO THE EUROPEAN SEARCH REPORT
## ON EUROPEAN PATENT APPLICATION NO.

EP 04 01 3360

This annex lists the patent family members relating to the patent documents cited in the above-mentioned European search report.
The members are as contained in the European Patent Office EDP file on
The European Patent Office is in no way liable for these particulars which are merely given for the purpose of information.

29-07-2004

| Patent document cited in search report | | Publication date | Patent family member(s) | | Publication date |
|---|---|---|---|---|---|
| JP 11224127 | A | 17-08-1999 | NONE | | |
| JP 09213465 | A | 15-08-1997 | JP | 3304738 B2 | 22-07-2002 |
| WO 9949101 | A | 30-09-1999 | WO<br>US | 9949101 A1<br>6301434 B1 | 30-09-1999<br>09-10-2001 |
| JP 10284382 | A | 23-10-1998 | WO<br>TW | 9845875 A1<br>389950 B | 15-10-1998<br>11-05-2000 |
| WO 9918602 | A | 15-04-1999 | TW<br>WO | 406336 B<br>9918602 A1 | 21-09-2000<br>15-04-1999 |
| US 5616024 | A | 01-04-1997 | JP<br>JP | 2647799 B2<br>7220862 A | 27-08-1997<br>18-08-1995 |